# EUROPÄISCHE PATENTANMELDUNG

(11) **EP 3 517 913 A1**
(43) Veröffentlichungstag der Anmeldung: **31.07.2019**
(21) Anmeldenummer: 19151497.5
(22) Anmeldetag: 11.01.2019
(51) Int. Cl.: G01K 17/20

(54) **VERFAHREN ZUM BESTIMMEN EINER ENERGIEEFFIZIENZ EINER IMMOBILIE**

(30) Priorität: 29.01.2018 DE 102018000669
(71) Anmelder: Grohe AG, 58675 Hemer (DE)
(72) Erfinder: Meier, Torsten, 41469 Neuss (DE); Depiere, Bert, 3150 Wakkerzeel (BE)

(57) **Zusammenfassung**

Verfahren zum Bestimmen einer Energieeffizienz einer Immobilie (1), aufweisend zumindest die folgenden Schritte:
a) Bestimmen eines Volumenstroms und einer ersten Temperatur eines Wärmeträgermediums, das von zumindest einer Heizeinrichtung (2) zu zumindest einer Wärmeübergabeeinrichtung (3.1 - 3.4) strömt;
b) Bestimmen zumindest einer zweiten Temperatur in der Immobilie (1) mittels zumindest eines Temperatursensors (4.1 - 4.4); und
c) Berechnen einer Energieeffizienz der Immobilie (1) auf Basis des Volumenstroms, der ersten Temperatur und der zweiten Temperatur.

## Beschreibung

Die vorliegende Erfindung betrifft ein Verfahren zum Bestimmen einer Energieeffizienz einer Immobilie, mittels dem Energiekennzahlen der Immobilie überwachbar sind.

In einigen Ländern werden maximale Energiebedarfswerte für Immobilien und eine Berechnung der jeweiligen Energiebedarfswerte für Immobilien vorgeschrieben. Die für eine Immobilie berechneten Energiebedarfswerte werden beispielsweise in einem Energieausweis festgehalten, der bei einem Mieterwechsel oder Eigentümerwechsel vorgelegt werden muss, um den Energiebedarf der Immobilie und damit zu erwartende Energiekosten offenzulegen. Die Berechnungsregeln für die energetische Bewertung der Immobilie sind regelmäßig ebenfalls vorgeschrieben und basieren unter anderem auf einer energetischen Bewertung der Immobilienhülle sowie der verwendeten Anlagentechnik, wie insbesondere der Heizungstechnik. Es hat sich jedoch herausgestellt, dass der tatsächliche Energiebedarf der Immobilie häufig von dem berechneten Energiebedarf abweicht, sodass überraschend hohe Energiekosten entstehen können.

Aufgabe der Erfindung ist es daher, die mit Bezug auf den Stand der Technik geschilderten Probleme zumindest teilweise zu lösen und insbesondere ein Verfahren zum Bestimmen einer Energieeffizienz einer Immobilie anzugeben, mittels dem der Energiebedarf der Immobilie überwachbar ist.

Diese Aufgabe wird gelöst mit einem Verfahren gemäß den Merkmalen des unabhängigen Patentanspruchs. Weitere vorteilhafte Ausgestaltungen der Erfindung sind in den abhängigen Patentansprüchen angegeben. Es ist darauf hinzuweisen, dass die in den abhängigen Patentansprüchen einzeln aufgeführten Merkmale in beliebiger technologisch sinnvoller Weise miteinander kombiniert werden können und weitere Ausgestaltungen der Erfindung definieren. Darüber hinaus werden die in den Patentansprüchen angegebenen Merkmale in der Beschreibung näher präzisiert und erläutert, wobei weitere bevorzugte Ausgestaltungen der Erfindung dargestellt werden.

Hierzu trägt ein Verfahren zum Bestimmen einer Energieeffizienz einer Immobilie bei, das zumindest die folgenden Schritte aufweist:
a) Bestimmen eines Volumenstroms und einer ersten Temperatur eines Wärmeträgermediums, das von zumindest einer Heizeinrichtung zu zumindest einer Wärmeübergabeeinrichtung strömt;
b) Bestimmen zumindest einer zweiten Temperatur in der Immobilie mittels zumindest eines Temperatursensors; und
c) Berechnen einer Energieeffizienz der Immobilie auf Basis des Volumenstroms, der ersten Temperatur und der zweiten Temperatur.

Bei der Energieeffizienz einer Immobilie handelt es sich insbesondere um ein Verhältnis zwischen Energie zu Energieeinsatz. Unter Energieeffizienz wird somit die möglichst sparsame bzw. wirtschaftliche Verwendung der Energie und des Energieeinsatzes verstanden, wobei Verluste, die beispielsweise bei der Wandlung, dem Transport und/oder der Speicherung der Energie entstehen, minimiert werden können. Bei der Immobilie kann es sich beispielsweise um ein Wohngebäude, ein Industriegebäude, ein Stockwerk eines Gebäudes, eine Wohnung oder ein Hotelzimmer handeln.

In Schritt a) wird ein Volumenstrom und eine erste Temperatur eines Wärmeträgermediums bestimmt, wobei das Wärmeträgermedium von zumindest einer Heizeinrichtung zu zumindest einer Wärmeübergabeeinrichtung strömt. Bei der Heizeinrichtung handelt es sich insbesondere um eine Vorrichtung zur Erwärmung der Immobilie, beispielsweise nach Art einer Zentralheizung, oder von einzelnen Räumen der Immobilie, beispielsweise nach Art einer Einzelheizung. Insbesondere kann es sich bei der Heizeinrichtung um eine Gasheizung, Ölheizung, Pelletheizung, Holzheizung, Elektroheizung oder Wärmepumpenheizung handeln. Die Heizeinrichtung erhitzt das flüssige Wärmeträgermedium, das anschließend über zumindest eine Heizkreisleitung, insbesondere mittels einer (Elektro-)Pumpe, der zumindest einen Wärmeübergabeeinrichtung zugeführt wird. Bei dem Wärmeträgermedium handelt es sich insbesondere um Wasser und/oder bei der zumindest einen Heizkreisleitung um zumindest eine Rohrleitung, die beispielsweise zumindest teilweise aus Metall, wie zum Beispiel Kupfer oder einer Kupferlegierung besteht. Die zumindest eine Heizkreisleitung kann dabei insbesondere einen Durchmesser von 10 mm (Millimeter) bis 80 mm aufweisen. Bei der zumindest einen Wärmeübergabeeinrichtung kann es sich beispielsweise um einen Radiator, insbesondere nach Art eines Heizkörpers, oder ein Flächenheizsystem, insbesondere nach Art einer Fußbodenheizung oder Wandheizung, handeln. Nach Erreichen der zumindest einen Wärmeübergabeeinrichtung wird das Wärmeträgermedium insbesondere zu der zumindest einen Heizeinrichtung zurückgeführt und dort durch die zumindest eine Heizeinrichtung wieder erhitzt. Somit wird das Wärmeträgermedium insbesondere durch einen Heizkreis geführt. Die zumindest eine Wärmeübergabeeinrichtung dient dabei insbesondere der Erwärmung einer Raumluft in der Immobilie.

Die Bestimmung des Volumenstroms und der ersten Temperatur des Wärmeträgermediums erfolgt insbesondere (unmittelbar) nach Verlassen der zumindest einen Heizeinrichtung, beispielsweise entlang der Heizkreisleitung stromabwärts in einem Abstand von weniger als 5 m (Meter), bevorzugt weniger als 2,5 m und besonders bevorzugt weniger als 1 m von der zumindest einen Heizeinrichtung. Bei der ersten Temperatur handelt es sich insbesondere um eine Vorlauftemperatur des Wärmeträgermediums. Zur Bestimmung des Volumenstroms und der ersten Temperatur des Wärmeträgermediums kann eine Messeinrichtung verwendet werden, die einen Durchflusssensor und einen Temperatursensor umfasst. Die Messeinrichtung kann mit einem Absperrventil und/oder einen Wasserzähler für die Heizkreisleitung kombiniert sein.

In Schritt b) wird zumindest eine zweite Temperatur in der Immobilie mittels zumindest eines Temperatursensors bestimmt. Mittels des zumindest einen Temperatursensors ist somit insbesondere bestimmbar, wieviel der durch die zumindest eine Heizeinrichtung erzeugten Wärmeenergie tatsächlich in der Immobilie genutzt wird und wieviel Verlust an der erzeugten Wärmeenergie entsteht.

In Schritt c) wird die Energieeffizienz der Immobilie auf Basis bzw. in Abhängigkeit des Volumenstroms, der ersten Temperatur und der zweiten Temperatur berechnet. Das Ergebnis kann einem Bewohner der Immobilie beispielsweise kontinuierlich über ein Display angezeigt werden. Zudem kann das Ergebnis an eine Cloud-Einrichtung gesendet werden, bei der es sich insbesondere um einen Server außerhalb der Immobilie handelt. Die Energieeffizienz der Immobilie kann ferner über die Cloud-Einrichtung beispielsweise mittels eines Smartphones abgefragt werden. Fällt die Energieeffizienz der Immobilie unter einen vorgebbaren Schwellenwert, kann der Bewohner der Immobilie beispielsweise mittels einer Push-Nachricht auf das Smartphone gewarnt werden. Der Bewohner kann dadurch ein möglicherweise energieineffizientes Verhalten, beispielsweise durch zu langes Lüften, beenden und somit die Energieeffizienz der Immobilie wieder erhöhen sowie einen CO2-Ausstoß der zumindest einen Heizeinrichtung reduzieren. Überraschend hohe Energiekosten können somit zudem vermieden werden.

Darüber hinaus kann in Schritt c) die Berechnung der Energieeffizienz zusätzlich auf Basis einer Außentemperatur erfolgt. Bei der Außentemperatur handelt es sich um eine Temperatur, die, insbesondere in der unmittelbaren Umgebung der Immobilie, außerhalb der Immobilie herrscht. Die Außentemperatur kann beispielsweise mit zumindest einem Außentemperatursensor bestimmt werden. Bei dem vorgeschlagenen Verfahren wird somit in Schritt a) die in die Immobilie eingebrachte Energie bestimmt, in Schritt b) ein Temperaturverlauf in der Immobilie oder in einzelnen Räumen der Immobilie bestimmt und in Schritt c) über die Außentemperatur, insbesondere aus Echtzeitdaten, ein Rückschluss auf die Energieeffizienz der Immobilie geschlossen.

Des Weiteren kann die Außentemperatur von einer Internetplattform abgefragt werden. Die Abfrage erfolgt insbesondere über das Internet und/oder für einen Standort der Immobilie. Bei der Internetplattform handelt es sich insbesondere um eine Webseite, auf der Wetterdaten, wie zum Beispiel Außentemperaturen, regelmäßig, d. h. insbesondere tagesaktuell und/oder stundenaktuell, veröffentlicht werden.

Weiterhin kann in Schritt b) eine Lufttemperatur in der Immobilie bestimmt werden. Hierzu kann der zumindest eine Temperatursensor fest oder beweglich, beispielsweise in oder auf der zumindest einen Wärmeübergabeeinrichtung, einem Boden und/oder einem Türstopper angeordnet sein.

Zudem kann die Lufttemperatur in sämtlichen Räumen der Immobilie bestimmt werden. Hierzu kann in jedem Raum der Immobilie zumindest ein Temperatursensor angeordnet sein.

Weiterhin kann eine Luftfeuchtigkeit in der Immobilie mit zumindest einem Luftfeuchtigkeitssensor bestimmt werden.

Ferner kann eine Vibration mit zumindest einem Vibrationssensor gemessen werden.

Darüber hinaus kann in Schritt c) bei der Berechnung der Energieeffizienz zumindest einer der folgenden Parameter berücksichtigt werden:
- Größe der Immobilie, insbesondere deren Grundfläche und/oder Volumen;
- Anzahl der Räume der Immobilie;
- Isolierung der Immobilie, insbesondere der Wandungen hin zur äußeren Umgebung der Immobilie;
- Leistung der zumindest einen Heizeinrichtung.

Des Weiteren kann in Schritt c) die Berechnung mit einer Steuerung erfolgen. Die Steuerung umfasst insbesondere zumindest einen Mikrocontroller. Weiterhin ist die Steuerung insbesondere datenleitend mit der Messeinrichtung, dem Durchflusssensor und dem mindestens einen Temperatursensor beispielsweise mittels einer Kabelverbindung und/oder Funkverbindung verbunden. Zudem kann die Steuerung auch datenleitend, beispielsweise mittels einer Kabelverbindung und/oder Funkverbindung, mit dem zumindest einen Außentemperatursensorverbunden sein. Bevorzugt ist, dass alle vorstehenden Komponenten einem miteinander kommunizierenden Netzwerk angehören.

Weiterhin kann in Schritt c) die Berechnung mit einer Cloud-Einrichtung erfolgen. Hierzu kann die Steuerung beispielsweise in der Cloud-Einrichtung ausgebildet sein. Alternativ kann die Steuerung beispielsweise über einen Netzwerkrouter und eine Internetverbindung mit der Cloud-Einrichtung verbunden sein.

Die Erfindung sowie das technische Umfeld wird nachfolgend anhand der Figur näher erläutert. Es ist darauf hinzuweisen, dass die Figur eine besonders bevorzugte Ausführungsvariante der Erfindung zeigt, diese jedoch nicht darauf beschränkt ist. Es zeigt beispielhaft und schematisch:

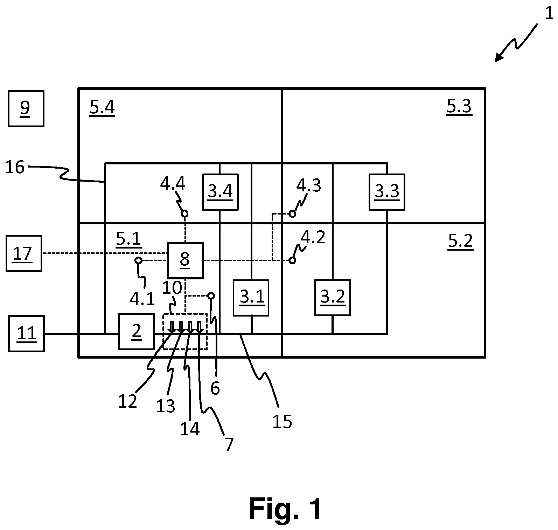

Fig. 1: eine Immobilie mit einer Heizeinrichtung.

Die Fig. 1 zeigt schematisch eine Immobilie 1 mit einer Heizeinrichtung 2. Die Heizeinrichtung 2 ist über eine Vielzahl von Heizkreisleitungen 15 mit einer Vielzahl von Wärmeübergabeeinrichtungen 3.1 - 3.4 verbunden, die sich jeweils in einem Raum 5.1 - 5.4 der Immobilie 1 befinden. Durch die Heizeinrichtung 2 ist ein Wärmeträgermedium erhitzbar und über die Heizkreisleitungen 15 den Wärmeübergabeeinrichtungen 3.1 - 3.4 zuführbar, sodass durch die Wärmeübergabeeinrichtung 3.1 - 3.4 eine Raumluft in den Räumen 5.1 - 5.4 erwärmbar ist. Das dabei zumindest teilweise abgekühlte Wärmeträgermedium ist anschließend über weitere Heizkreisleitungen 15 der Heizeinrichtung 2 rückführbar. Durch die Heizkreisleitungen 15 wird somit ein Heizkreis 16 in der Immobilie 1 gebildet. Dem Heizkreis 16 ist durch eine Flüssigkeitsquelle 11, beispielsweise einem öffentlichen Wasserversorgungsnetz, das Wärmeträgermedium zuführbar, falls in dem Heizkreis 16 Verluste an Wärmeträgermedium, beispielsweise durch Leckagen, entstehen. Unmittelbar stromabwärts der Heizeinrichtung 2 ist eine Messeinrichtung 10 mit einem ersten Temperatursensor 12, einem Durchflusssensor 13, einem Drucksensor 14 und einem Vibrationssensor 7 angeordnet. Mittels des ersten Temperatursensors 12 ist eine Temperatur des Wärmeträgermediums in der Heizkreisleitung 15, mittels dem Durchflusssensor 13 ein Volumenstrom des durch die Heizkreisleitung 15 strömenden Wärmeträgermediums und mittels dem Drucksensor 14 ein Druck des durch die Heizkreisleitung 15 strömenden Wärmeträgermediums bestimmbar. Weiterhin sind mittels des Vibrationssensors 7 Vibrationen an den Heizkreisleitungen 15 messbar. Zur Übertragung der durch die Sensoren gemessenen Messwerte ist die Messeinrichtung 10 datenleitend mit einer Steuerung 8 verbunden. Weiterhin ist die Steuerung 8 datenleitend mit in den einzelnen Räumen 5.1 - 5.4 befindlichen zweiten Temperatursensoren 4.1 - 4.4 zur Bestimmung einer Lufttemperatur in den einzelnen Räumen 5.1 - 5.4 sowie einem in dem Raum 5.1 befindlichen Luftfeuchtigkeitssensor 6 zur Bestimmung einer Luftfeuchtigkeit in dem Raum 5.1 verbunden. Hierbei ist anzumerken, dass in jedem Raum 5.1 - 5.4 ein Luftfeuchtigkeitssensor 6 angeordnet sein kann. Zudem ist die Steuerung 8 mit einem Außentemperatursensor 17 verbunden, mittels dem eine Außentemperatur bestimmbar ist. Der Außentemperatursensor 17 ist ebenfalls datenleitend mit der Steuerung 8 verbunden. Mittels der Steuerung 8 ist somit eine Energieeffizienz der Immobilie 1 berechenbar. Die Steuerung 8 kann sich in der Immobilie 1 befinden und/oder in einer Cloud-Einrichtung 9 ausgebildet sein.

Durch die vorliegende Erfindung ist der Energiebedarf der Immobilie kontinuierlich überwachbar.

### Bezugszeichenliste

- 1: Immobilie
- 2: Heizeinrichtung
- 3.1 - 3.4: Wärmeübergabeeinrichtung
- 4.1 - 4.4: zweiter Temperatursensor
- 5.1 - 5.4: Raum
- 6: Luftfeuchtigkeitssensor
- 7: Vibrationssensor
- 8: Steuerung
- 9: Cloud-Einrichtung
- 10: Messeinrichtung
- 11: Flüssigkeitsquelle
- 12: erster Temperatursensor
- 13: Durchflusssensor
- 14: Drucksensor
- 15: Heizkreisleitung
- 16: Heizkreis
- 17: Außentemperatursensor

## Patentansprüche

1. Verfahren zum Bestimmen einer Energieeffizienz einer Immobilie (1), aufweisend zumindest die folgenden Schritte:
a) Bestimmen eines Volumenstroms und einer ersten Temperatur eines Wärmeträgermediums, das von zumindest einer Heizeinrichtung (2) zu zumindest einer Wärmeübergabeeinrichtung (3.1 - 3.4) strömt;
b) Bestimmen zumindest einer zweiten Temperatur in der Immobilie (1) mittels zumindest eines Temperatursensors (4.1 - 4.4); und
c) Berechnen einer Energieeffizienz der Immobilie (1) auf Basis des Volumenstroms, der ersten Temperatur und der zweiten Temperatur.

2. Verfahren nach Patentanspruch 1, wobei in Schritt c) die Berechnung der Energieeffizienz zusätzlich auf Basis einer Außentemperatur erfolgt.

3. Verfahren nach Patentanspruch 2, wobei die Außentemperatur von einer Internetplattform abgefragt wird.

4. Verfahren nach einem der vorhergehenden Patentansprüche, wobei in Schritt b) eine Lufttemperatur in der Immobilie (1) bestimmt wird.

5. Verfahren nach Patentanspruch 4, wobei die Lufttemperatur in sämtlichen Räumen (5.1 - 5.4) der Immobilie (1) bestimmt wird.

6. Verfahren nach einem der vorhergehenden Patentansprüche, wobei eine Luftfeuchtigkeit in der Immobilie (1) mit zumindest einem Luftfeuchtigkeitssensor (6) bestimmt wird.

7. Verfahren nach einem der vorhergehenden Patentansprüche, wobei eine Vibration mit zumindest einem Vibrationssensor (7) gemessen wird.

8. Verfahren nach einem der vorhergehenden Patentansprüche, wobei in Schritt c) bei der Berechnung der Energieeffizienz zumindest einer der folgenden Parameter berücksichtigt wird:
- Größe der Immobilie (1);
- Anzahl der Räume (5.1 - 5.4) der Immobilie (1);
- Anzahl der Räume (5.1 - 5.4) mit zumindest einem Temperatursensor (4.1 - 4.4);
- Isolierung der Immobilie (1);
- Leistung der zumindest einen Heizeinrichtung (2).

9. Verfahren nach einem der vorhergehenden Patentansprüche, wobei in Schritt c) die Berechnung mit einer Steuerung (8) erfolgt.

10. Verfahren nach einem der vorhergehenden Patentansprüche, wobei in Schritt c) die Berechnung mit einer Cloud-Einrichtung (9) erfolgt.
